# EUROPEAN PATENT APPLICATION

(11) **EP 3 623 495 A1**
(43) Date of publication of application: **18.03.2020**
(21) Application number: 18918475.7
(22) Date of filing: 30.08.2018
(51) Int. Cl.: C23C 14/24, H01L 51/50

(54) **MASK PLATE AND MASK ASSEMBLY**

(30) Priority: 14.05.2018 CN 201810454597
(71) Applicant: Kunshan Go-Visionox Opto-Electronics Co., Ltd., KunShan City, Jiangsu 215300 (CN)
(72) Inventor: LI, Jinku, Jiangsu 215300 (CN); KANG, Menghua, Jiangsu 215300 (CN); WANG, Mengfan, Jiangsu 215300 (CN)
(74) Representative: D'Halleweyn, Nele Veerle Trees Gertrudis
(86) International application number: PCT/CN2018/103296
(87) International publication number: WO 2019/218536

(57) **Abstract**

A mask plate and a mask assembly, the mask plate comprising a mask plate body, and at least one sub-mask plate provided on the mask plate body which comprises an evaporation area and a shielding part. In the thickness direction of the sub-mask plate, the evaporation area is provided with a first evaporation hole penetrating the sub-mask plate; the shielding part comprises an isolation area and a dummy area, the dummy area corresponding to a special area of a display screen; the isolation area is located between the dummy area and the evaporation area; and in the thickness direction of the sub mask plate, the dummy area is provided with a second evaporation hole penetrating the sub-mask plate, and/or the dummy area is provided with at least one first groove of which the depth is smaller than the thickness of the sub mask plate.

## Description

### TECHNICAL FIELD

The present disclosure relates to the field of display technologies, and more particularly relates to a mask and a mask assembly.

### BACKGROUND

An Organic Light-Emitting Diode (OLED) is also known as an organic electroluminescence display or an organic light-emitting semiconductor. OLED has many characteristics such as low driving voltage, active light emission, wide viewing angle, high efficiency, fast response, easy realization of full-color large-area wall-mounted display and flexible display, and gradually replaces the Liquid Crystal Display (LCD).

In an OLED manufacturing technology, a mask for vacuum evaporation is a critical component, and the mask can control a position where organic materials are deposited on a substrate. The mask mainly includes a Common Metal Mask (CMM) and a Fine Metal Mask (FMM). The CMM is used for evaporation of a common layer, and the FMM is used for evaporation of a light-emitting layer.

The inventors have found that, during the process of manufacturing an irregular-shaped display screen (i.e., a display screen having a groove or a hole at one side of the display screen), wrinkles are likely to occur when the mask in the prior art is used to be tensioned, resulting in a decrease in an accuracy of an pixel evaporation position of the subsequent display screen.

### SUMMARY

Accordingly, the present disclosure provides a mask and a mask assembly, which solves the problem of easy wrinkling when the mask is tensioned, and improves the accuracy of the pixel evaporation position of the subsequent display screen.

To achieve the above object, the present disclosure provides a mask. The mask includes: a mask body, the mask body has an evaporation surface and a glass surface, the evaporation surface is disposed facing an evaporation source, the glass surface is disposed away from the evaporation source; and at least one sub-mask disposed on the mask body. The sub-mask includes an evaporation area and a shielding portion. The evaporation area is provided with a first evaporation hole penetrating the sub-mask in a thickness direction of the sub-mask. The shielding portion includes an isolation area and a dummy area, the dummy area corresponds to an irregular-shaped area of a display screen, and the isolation area is located between the dummy area and the evaporation area. The dummy area is provided with a second evaporation hole penetrating the sub-mask in the thickness direction of the sub-mask, and/or the dummy area is provided with at least one first groove, a depth of the first groove is less than a thickness of the sub-mask.

In one of the embodiments, the second evaporation hole has a shape same to that of the first evaporation hole.

In one of the embodiments, the second evaporation hole includes a first half-etching hole and a second half-etching hole which are disposed along the thickness direction of the sub-mask and in communication with each other. The first half-etching hole is disposed on the glass surface, and the second half-etching hole is disposed on the evaporation surface. The first half-etching hole gradually shrinks from one end of the mask body adjacent to the glass surface to the other end of the mask body away from the glass surface, and the second half-etching hole gradually shrinks from one end of the mask body adjacent to the evaporation surface to the other end of the mask body away from the evaporation surface and is in communication with the first half-etching hole.

In one of the embodiments, a projection of an opening of the first half-etching hole along the thickness direction of the sub-mask is located within an opening of the second half-etching hole.

In one of the embodiments, the first groove is disposed on the evaporation surface or the glass surface.

In one of the embodiments, the first groove includes a second groove and a third groove, the second groove is disposed on the evaporation surface, and the third groove is disposed on the glass surface. An interval is formed between a bottom wall of the second groove and a bottom wall of the third groove along the thickness direction of the sub-mask (i.e., the second groove and the third groove are not in communication with each other).

In one of the embodiments, a cross-section of the first groove has a shape of polygonal, circular, or elliptical.

In one of the embodiments, the isolation area is provided with at least one fourth groove in the thickness direction of the sub-mask, and a depth of the fourth groove is less than the thickness of the sub-mask.

In one of the embodiments, the fourth groove is disposed on the evaporation surface or the glass surface.

In one of the embodiments, the fourth groove includes a fifth groove and a sixth groove, the fifth groove is disposed on the evaporation surface, and the sixth groove is disposed on the glass surface. An interval is formed between a bottom wall of the fifth groove and a bottom wall of the sixth groove along the thickness direction of the sub-mask.

In one of the embodiments, a depth of the fifth groove is greater than or equal to a depth of the sixth groove.

In one of the embodiments, a cross-section of the fourth groove has a shape of polygonal, circular, or elliptical.

In one of the embodiments, the mask body has a first center line and a second center line in a plan. The first center line is perpendicular to the second center line. The mask body is provided with two sets of the sub-masks, each set of the sub-masks includes at least one of the sub-masks. An interval is formed between adjacent two sub-masks. The two sets of the sub-masks are axisymmetric with respect to the first center line, and the two sets of the sub-masks are axisymmetric with respect to the second center line.

In one of the embodiments, the shielding portions of the sub-masks located on a same side of the second center line are disposed away from or facing to the second center line.

In one of the embodiments, the mask body is provided with a plurality of sub-masks, the plurality of sub-masks are disposed in a row or in an array;
the mask body has a virtual dividing line, the virtual dividing line divides the plurality of sub-masks into two sets of sub-masks, the two sets of sub-masks includes: a first set of sub-masks located on one side of the virtual dividing line and a second set of sub-masks located on the other side of the virtual dividing line; the first set of sub-masks and the second set of sub-masks includes at least one sub-mask, respectively;
each of the sub-masks of the first set of sub-masks and the second set of sub-masks is provided with the shielding portion on a side facing the virtual dividing line, respectively; or each of the sub-masks of the first set of sub-masks and the second set of sub-masks is provided with the shielding portion on a side facing away from the virtual dividing line, respectively.

In one of the embodiments, the virtual dividing line is a virtual straight line.

In one of the embodiments, the mask body is provided with a plurality of sub-masks, the plurality of sub-masks are disposed in a row or in an array;
a plurality of sequentially adjacent sub-sets of sub-masks are formed by an even number of the sequentially adjacent sub-masks in a same row, each of the sub-sets of the sub-masks includes two sub-masks disposed adjacent to each other;
opposite sides of the two sub-masks of each of the sub-sets of the sub-masks are provided with the shielding portions, respectively, sides thereof facing away from each other are not provided with the shielding portions; or opposite sides of the two sub-masks of each of the sub-sets of the sub-masks are not provided with the shielding portions, sides thereof facing away from each other are provided with the shielding portions, respectively.

In one of the embodiments, the isolation area is a virtual line matching a contour line of a recessed portion of the evaporation area.

A mask assembly includes a mask frame, a support strip, and at least one mask of any one of claims 1 to 19. The support strip is fixedly connected to the mask frame, at least one of the masks is laminated on the support strip and fixedly connected with the mask frame.

In one of the embodiments, the isolation area is a virtual line matching a contour line of a recessed portion of the evaporation area.

In the mask and the mask assembly provided by the present disclosure, the shielding portion is divided into two parts, and the dummy area is provided with the second evaporation hole and/or the first groove. When the mask is used for evaporation, evaporation materials can be evaporated onto the substrate from the first evaporation hole and the second evaporation hole. The arrangement of the second evaporation hole and/or the first groove can reduce the weight of the shielding portion, reduce the difference in weight between the shielding portion and the evaporation area, and reduce the stress concentration of the shielding portion, thereby making the mask body uniformly stressed during tensioning, and further reducing the wrinkle phenomenon of the mask body during tensioning. In addition, the isolation area is disposed between the dummy area and the evaporation area to facilitate cutting and packaging of the subsequently manufactured display screen.

### BRIEF DESCRIPTION OF THE DRAWINGS

FIG. 1 is a schematic diagram of a mask according to an embodiment of the present disclosure;
FIG. 2 is a schematic diagram of a mask according to another embodiment of the present disclosure;
FIG. 3 is a schematic diagram of a mask according to yet another embodiment of the present disclosure;
FIG. 4 is a schematic diagram of a mask according to yet another embodiment of the present disclosure;
FIG. 5 is a schematic diagram of a mask according to yet another embodiment of the present disclosure;
FIG. 6 is a partial cross-sectional diagram of a mask according to an embodiment of the present disclosure;
FIG. 7 is a partial cross-sectional diagram of a mask according to another embodiment of the present disclosure;
FIG. 8 is a partial cross-sectional diagram of a mask according to yet another embodiment of the present disclosure;
FIG. 9 is a partial cross-sectional diagram of a mask according to yet another embodiment of the present disclosure;
FIG. 10 is a partial cross-sectional diagram of a mask according to yet another embodiment of the present disclosure;
FIG. 11 is a partial cross-sectional diagram of a mask according to yet another embodiment of the present disclosure;
FIG. 12 is a partial cross-sectional diagram of a mask according to yet another embodiment of the present disclosure;
FIG. 13 is a partial cross-sectional diagram of a mask according to yet another embodiment of the present disclosure;
FIG. 14 is a partial cross-sectional diagram of a mask according to yet another embodiment of the present disclosure; and
FIG. 15 is a schematic diagram of a mask assembly according to an embodiment of the present disclosure.

### DETAILED DESCRIPTION OF THE EMBODIMENTS

In order to facilitate the understanding of the present disclosure, the present disclosure will be described more fully hereinafter with reference to the accompanying drawings. Preferred embodiments of the present disclosure are shown in the drawings. The disclosure may, however, be embodied in many different forms and are not limited to the embodiments described herein. Rather, these embodiments are provided so as to understand contents disclosed in this disclosure more thoroughly and completely.

As described in the background, the use of a mask in the prior art is prone to the problem of wrinkles when tensioning. The inventors have found that the root cause of such a problem is that a screen body having a groove needs to be opened at a corresponding position during the manufacturing process. That is, there is a shielding portion on the mask, and since the structure of the shielding portion and an evaporation area are greatly different, for example, the evaporation area is provided with an evaporation hole and the shielding portion is not provided with the evaporation hole, a difference between the weight (weight per unit area) of the shielding portion and the evaporation area is great, and a stress is easily concentrated on the shielding portion. When the stress is concentrated on the shielding portion, the uneven force will lead to the occurrence of wrinkles.

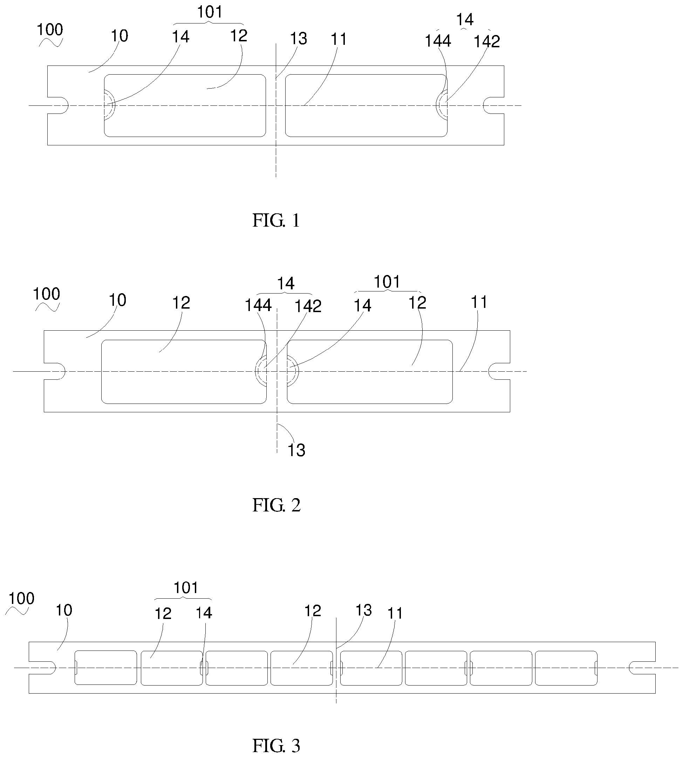

Accordingly, referring to FIG. 1, FIG. 2, and FIG. 6, an embodiment of the present disclosure provides a mask 100, including a mask body 10. At least one sub-mask 101 is disposed on the mask body 10. The sub-mask 101 includes an evaporation area 12 and a shielding portion 14. The evaporation area 12 is provided with a first evaporation hole 122 penetrating the sub-mask 101 in a thickness direction of the sub-mask 101. The evaporation area 12 is used for evaporation of a display panel or a display screen. That is, a size of the evaporation area 12 is preferably exactly the same as a size of the display panel or the display screen that needs to be evaporated.

In alternative embodiments, the size of the evaporation area 12 may be slightly greater than the size of the display panel or the display screen that needs to be evaporated, so that another shielding structure may be added to the mask 100 to further reduce wrinkles.

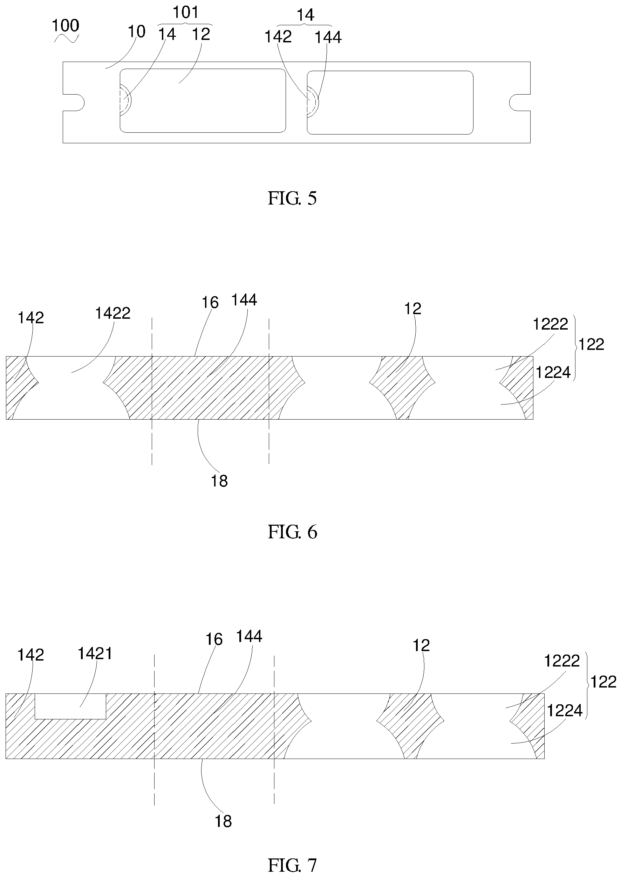

Further referring to FIG. 1 and FIG. 2, and with reference to FIG. 6, the shielding portion 14 includes a dummy area 142 and an isolation area 144. A shape and position of the dummy area 142 correspond to those of an irregular-shaped area of an irregular-shaped display screen (the irregular-shaped area is, for example, an area with a groove or a hole), respectively. The isolation area 144 is disposed between the dummy area 142 and the evaporation area 12. The dummy area 142 is provided with a second evaporation hole 1422 penetrating the sub-mask 101 in the thickness direction of the sub-mask 101.

In this way, the shielding portion 14 is divided into two parts, and the dummy area 142 is provided with the second evaporation hole 1422. When the mask 100 is used for evaporation, evaporation materials can be evaporated onto the substrate from the first evaporation hole 122 and the second evaporation hole 1422. The arrangement of the second evaporation hole 1422 can reduce the weight of the shielding portion 14, reduce the difference in weight between the shielding portion 14 and the evaporation area 12, and reduce the stress concentration of the shielding portion 14, thereby making the mask body 10 uniformly stressed during tensioning, and further reducing the wrinkle phenomenon of the mask body 10 during tensioning. In addition, the isolation area 144 is disposed between the dummy area 142 and the evaporation area 12 to facilitate cutting and packaging of the subsequently manufactured display screen.

In the present embodiment, a shape of the mask body 10 is not limited, and may be, for example, a regular cuboid shape or a circular shape. In alternative embodiments, other irregular shapes may also be selected, such as the opposite two sides of the mask body 10 being straight lines, and other opposite two sides being arc irregular-shape. In addition, a shape of the evaporation area 12 is also not limited, and may be, for example, a rectangular shape or a circular shape. When the evaporation area 12 is rectangular, a recessed portion (for example, a portion surrounded by the shielding portion 14 in FIG. 1) is formed on one side or a plurality of sides of the evaporation area 12. A shape of the shielding portion 14 is also not limited, and may be, for example, an arc shielding portion 14 or a polygonal shielding portion 14.

Specifically, the mask body 10 has two sets of sub-masks 101, and each set of the sub-masks 101 includes at least one sub-mask 101, and an interval is formed between adjacent two sub-masks 101. The mask body 10 includes a first center line 11 and a second center line 13, and the first center line 11 is perpendicular to the second center line 13. Preferably, the two sets of sub-masks 101 are self-axisymmetric with respect to the first center line 11, and the two sets of sub-masks 101 are axisymmetric with respect to the second center line 13. It should be understood that, in FIG. 1 to FIG. 3, one set of sub-masks 101 (a first set) is located on a left side of the second center line 13, and another set of sub-masks 101 (a second set) is located on a right side of the second center line 13. Each set of sub-masks 101 in FIG. 1 and FIG. 2 includes one sub-mask 101, respectively. In FIG. 3, each set of sub-masks 101 includes four sub-masks 101 disposed in a horizontal row. Of course, in alternative embodiments, each set of sub-masks 101 may further include sub-masks 101 disposed in an array (for example, not less than two rows and two columns).

Preferably, two sets of sub-masks 101 are disposed axi-symmetrically with respect to the first center line 11 and the second center line 13, and the number of the shielding portions 14 located on the two sides of the first center line 11 and the second center line 13 is the same. At this time, the mask body 10 is uniformly stressed on both sides of the first center line 11 and the second center line 13 during tensioning, the wrinkles at the position of the shielding portion 14 are further reduced, and an tensioning accuracy is improved, so that the accuracy of the pixel evaporation position of the subsequent display screen is high, and the display effect of an opening area (i.e., the irregular-shaped area) of the subsequent display screen is also improved.

In one embodiment, further referring to FIG. 1, if a first direction (transverse or left-right direction) is configured to be parallel to the first center line 11, and a second direction (longitudinal or up-down direction) is configured to be parallel to the second center line 13, the mask body 10 is provided with a row of sub-masks 101 in the transverse direction. When a line connecting centers of the left and right sides of the mask body 10 in FIG. 1 is the first center line 11, and a line connecting centers of the upper and lower sides thereof is the second center line 13, the shielding portions 14 of the sub-masks 101 located on the same side of the second center line 13 are disposed facing away from the second center line 13. In other words, the shielding portion 14 on each of the sub-masks 101 located on the same side of the second center line 13 is disposed on a side of each of the sub-mask 101 away from the second center line 13.

In another embodiment, further referring to FIG. 2, a row of sub-masks 101 is transversely disposed on the mask body 10. When a line connecting centers of the left and right sides of the mask body 10 in FIG. 2 is the first center line 11, and a line connecting centers of the upper and lower sides thereof is the second center line 13, the shielding portions 14 of the sub-masks 101 located on the same side of the second center line 13 are disposed facing the second center line 13. In other words, the shielding portion 14 of each of the sub-masks 101 located on the same side of the second center line 13 is disposed on a side of each of the sub-mask 101 adjacent to the second center line 13.

In another embodiment, further referring to FIG. 3, a row of sub-masks 101 is transversely disposed on the mask body 10. When a line connecting centers of the left and right sides of the mask body 10 in FIG. 3 is the first center line 11, and a line connecting centers of the upper and lower sides thereof is the second center line 13, a set of sub-masks 101 located on the same side of the second center line 13 may be configured to include at least one sub-set of sub-masks 101. Each of the sub-sets of the sub-masks 101 includes two adjacent sub-masks 101. The shielding portions 14 of the two sub-masks 101 of each of the sub-sets of the sub-masks 101 are preferably disposed opposite to each other.

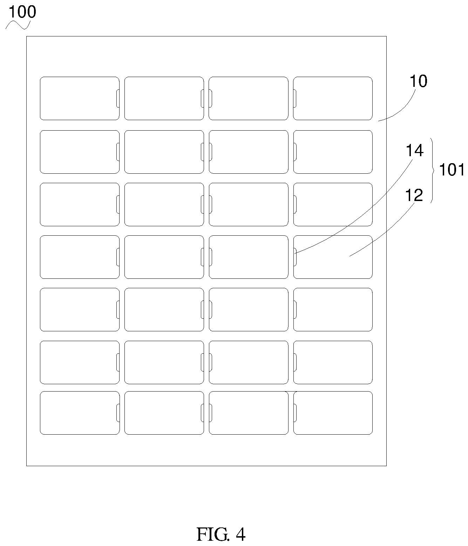

In yet another embodiment, referring to FIG. 4, the mask body 10 is provided with a plurality of rows of sub-masks 101 in a form of an array, that is, the plurality of sub-masks 101 are arranged in a plurality of (transverse) rows and (longitudinal) columns. The plurality of sub-masks 101 of each row of sub-masks 101 are sequentially arranged substantially uniformly along the left-right direction, and an interval between adjacent two rows of sub-masks 101 is substantially uniform. When a line connecting centers of the left and right sides of the mask body 10 in FIG. 4 is the first center line 11, and a line connecting centers of the upper and lower sides thereof is the second center line 13, preferably, the shielding portions 14 of the sub-masks 101 located on the same side of the second center line 13 are disposed facing the second center line 13. In another embodiment, the shielding portions 14 of the sub-masks 101 located on the same side of the second center line 13 may also be disposed facing away from the second center line 13, so that the amount of sagging during tensioning can be reduced to further improve the tensioning wrinkles. In another embodiment, the sub-masks 101 in each row located on the same side of the second center line 13 may also be disposed to include at least one sub-set of sub-masks 101. Each of the sub-sets of the sub-masks 101 includes two adjacent sub-masks 101, respectively. The shielding portions 14 of the two sub-masks 101 of each of the sub-sets of the sub-masks 101 are oppositely disposed.

Referring to FIG. 5, in alternative embodiments, when the sum of the sub-masks 101 included in the two sets of sub-masks 101 is still an even number, the two sets of sub-masks 101 can be symmetrically disposed only with respect to one of the center lines. When a line connecting centers of the left and right sides of the mask body 10 in FIG. 5 is the first center line 11 (not shown in FIG. 5), and a line connecting centers of the upper and lower sides thereof is the second center line 13 (not shown in FIG. 5), the two sets of sub-masks 101 are only axisymmetric with respect to the first center line 11, not axisymmetric with respect to the second center line 13 at this time. In another embodiment, the two sets of sub-masks 101 may also be only axisymmetric with respect to the second center line 13 and not axisymmetric with respect to the first center line 11.

In alternative embodiments, the total number of the sub-masks 101 may be selected to be an odd number, in which case the sub-masks 101 are only symmetrical with respect to one of the first center line and the second center line, and not asymmetrical with respect to another center line.

In other embodiments, the two sets of sub-masks 101 can also be disposed asymmetrically with respect to the first center line 11 and the second center line 13.

In the present embodiment, the isolation area 144 can be a virtual line that matches a contour line of the recessed portion of the evaporation area 12, and then a dummy portion 142 may occupy the entire shielding portion 14.

In another embodiment, the isolation area 144 occupies a portion of the shielding portion 14, that is, the isolation area 144 is no longer merely a virtual line that matches the contour line of the evaporation area 12, but an actually existing isolation area. At this case, the proportion of the isolation area 144 occupying the shielding portion 14 is not limited, as long as the range of a cutting area corresponding to the isolation area 122 in the finally obtained display screen is ensured to satisfy the cutting required for cutting and packaging allowance. The boundary between the isolation area 144 and the evaporation area 12 is theoretically a cutting boundary line when the display screen is subjected to a cutting operation to form an irregular-shaped area. When the isolation area 144 occupies a portion of the shielding portion 14, no evaporation material will be evaporated onto the substrate at a position of the substrate corresponding to the isolation area 144. After the evaporation, the cutting and packaging may be performed at a position of the display screen corresponding to the isolation area 144 of the mask 100 (i.e., a portion of the display screen corresponding to the dummy area 142 is cut away). Since no evaporation material exists in the position corresponding to the isolation area 144, it will not cause water and oxygen infiltration, and the later packaging effect is good.

Further referring to FIG. 6, in the present embodiment, the first evaporation hole 122 and the second evaporation hole 1422 have a substantially same shape. In addition, when there are a plurality of the first evaporation holes 122 and the second evaporation holes 1422, an arrangement of the second evaporation holes 1422 in the dummy area 142 is preferably the same as an arrangement of the first evaporation holes 122 in the evaporation area 12. That is, except for the isolation area 144, the dummy area 142 and the evaporation area 12 can be regarded as a whole portion. The plurality of first evaporation holes 122 and the plurality of second evaporation holes 1422 are provided on the whole portion with an interval therebetween.

Specifically, the aforementioned arrangement is that, the arrangement of the second evaporation holes 1422 in the dummy area 142 is substantially the same as the arrangement of the first evaporation holes 122 in the evaporation area 12 in the first direction and/or in the second direction. For example, the first evaporation holes 122 are arranged in rows in the evaporation area 12, and the second evaporation holes 1422 are extensions of the first evaporation holes 122 arranged in rows. In addition, an interval between adjacent two second evaporation holes 1422 in each row is the same as an interval between adjacent two first evaporation holes 122 in each row. At the same time, the first evaporation holes 122 are arranged in columns in the evaporation area 12, and an interval between adjacent two second evaporation holes 1422 in each column is the same as an interval between adjacent two first evaporation holes 122 in each column.

In alternative embodiments, the shapes and arrangement of the first evaporation holes 122 and the second evaporation holes 1422 may be selected to be different, and may be set according to actual needs, and are not limited herein. For example, the interval between adjacent two second evaporation holes 1422 in each row may be configured to be different from the interval between adjacent two first evaporation holes 122 in each row. Alternatively, the interval between adjacent two second evaporation holes 1422 in each column is configured to be different from the interval between adjacent two first evaporation holes 122 in each column.

In addition, it should be understood that, the number of the first evaporation holes 122 and the second evaporation holes 1422 on one sub-mask 101 may be one.

In one embodiment, the first evaporation hole 122 includes a first half-etching hole 1222 and a second half-etching hole 1224 which are disposed along a thickness direction of the evaporation area 12 and in communication with each other. The second evaporation hole 1422 also includes the first half-etching hole 1222 and the second half-etching hole 1224 which are disposed along the thickness direction of the dummy area 142 and in communication with each other. That is, the evaporation holes are formed by two half-etching methods from the glass surface 16 and the evaporation surface 18, respectively, which can ensure that edges of the formed evaporation holes are smooth, so that the subsequent evaporation effect of the organic materials is better. Although in the present embodiment, longitudinal cross-sectional shapes of the first half-etching hole 1222 and the second half-etching hole 1224 are different along the thickness direction of the sub-mask 101, in alternative embodiments, the longitudinal cross-sectional shapes of the first half-etching hole 1222 and the second half-etching hole 1224 may be the same.

Preferably, the first half-etching hole 1222 is disposed on the glass surface 16 of the mask body 10, and the second half-etching hole 1224 is disposed on the evaporation surface 18 of the mask body 10. The glass surface 18 is a surface of the mask body 10 away from an evaporation source, and the evaporation surface 18 is a surface of the mask body 10 adjacent to the evaporation source. The first half-etching hole 1222 gradually shrinks from one end adjacent to the glass surface 16 to the other end away from the glass surface 16. The second half-etching hole 1224 gradually shrinks from one end adjacent to the evaporation surface 18 to the other end away from the evaporation surface 18. Finally, the first half-etching hole 1222 is in communication with the second half-etching hole 1224 at a substantially central position of the mask body 10 along the thickness direction thereof. Preferably, a size of an opening of the second half-etching hole 1224 (i.e., an opening of the second half-etching hole 1224 with respect to the evaporation surface 18) covers a size of an opening of the first half-etching hole 1222 (i.e., an opening of the first half-etching hole 1222 with respect to the glass surface 16), thereby ensuring that the evaporation materials entering the first evaporation hole 122 from the first half-etching hole 1224 can be filled with the first half-etching hole 1222. That is, a projection of the opening of the first half-etching hole 1222 along the thickness direction of the sub-mask 101 (also the thickness direction of the mask body 10) can be completely located within the opening of the second half-etching hole 1224.

Preferably, in the present embodiment, cross-sectional shapes (cross-sectional shapes in a direction perpendicular to the paper surface) of the first half-etching hole 1222 and the second half-etching hole 1224 are both rectangular. However, in alternative embodiments, the cross-sectional shapes of the first half-etching hole 1222 and the second half-etching hole 1224 can be selected to be circular or elliptical.

In alternative embodiments, referring to FIG. 7 to FIG. 9, the dummy area 142 is provided with at least one first groove 1421 in the thickness direction of the sub-mask 101, and a depth of the first groove 1421 is less than the thickness of the sub-mask 101.

In this way, the shielding portion 14 is divided into two parts, and the dummy area 142 is provided with the first groove 1421. The arrangement of the first groove 1421 can reduce the weight of the shielding portion 14, reduce the difference in weight between the shielding portion 14 and the evaporation area 12, and reduce the stress concentration of the shielding portion 14, thereby making the mask body 10 uniformly stressed during tensioning, and further reducing the wrinkle phenomenon of the mask body 10 during tensioning. In addition, the isolation area 144 is disposed between the dummy area 142 and the evaporation area 12 to facilitate cutting and packaging of the subsequently manufactured display screen.

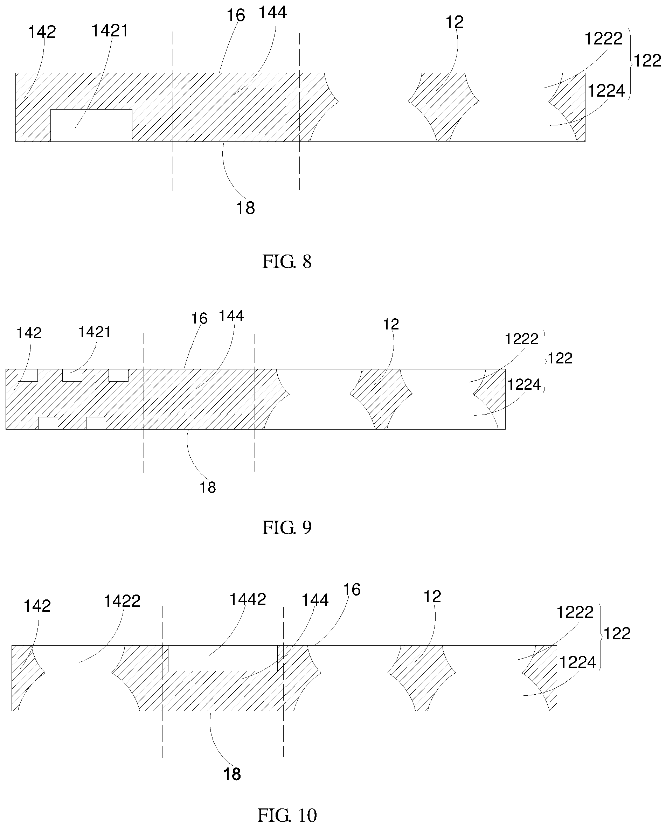

More specifically, the first groove 1421 can be provided in the dummy area 142 in one of the following three ways:
1. The first groove 1421 is only provided on the glass surface 16 of the dummy area 142 (referring to FIG. 7).
2. The first groove 1421 is only provided on the evaporation surface 18 of the dummy area 142 (referring to FIG. 8).
3. The first groove 1421 is provided both on the evaporation surface 18 and the glass surface 16 of the dummy area 142 (referring to FIG. 9).

In one embodiment, the first groove 1421 is provided on the evaporation surface of the dummy area 142, that is, the first groove 1421 is only provided on the evaporation surface of the dummy area 142. In alternative embodiments, the first groove 1421 can also be provided only on the glass surface of the dummy area 142 (referring to FIG. 7).

Specifically, referring to FIG. 8, the number of the first grooves 1421 provided on the evaporation surface 18 of the dummy area 142 is one, and one first groove 1421 is provided on the evaporation surface of the dummy area 142 in a half-etching manner. In the present embodiment, the first groove 1421 can be disposed to cover the entire area of the evaporation surface of the dummy area 142, or the first groove 1421 can be disposed to cover most area of the evaporation surface of the dummy area 142. In addition, the cross-section of the first groove 1421 may have a shape of polygonal, such as triangular, rectangular, or pentagonal, or may also have a shape of circular or elliptical. When the first groove 1421 covers the entire area of the evaporation surface of the dummy area 142, a bottom wall of the first groove 1421 is exactly the same size as the evaporation surface of the dummy area 142 of the shielding portion 14, and the bottom wall of the first groove 1421 can serve as the evaporation surface of the shielding portion 14.

In another embodiment, the number of the first grooves 1421 provided on the evaporation surface 18 of the dummy area 142 is at least two. An interval is formed between adjacent two first grooves 1421. The at least two first grooves 1421 can be provided on the evaporation surface 18 of the dummy area 142 in a stripe half-etching or a dotted half-etching manner. When the first groove 1421 is stripe half-etched, the cross-section of the first groove 1421 is an elongated shape. When the first groove 1421 is dotted half-etched, the cross-section of the first groove 1421 has a shape of circular or elliptical. In alternative embodiments, when the first groove 1421 is stripe half-etched, a long side of the stripe cross-section of the first groove 1421 extends along a direction of a long side of the mask body 10 to further reduce the tensioning wrinkles of the mask 100.

Referring to FIG. 9, in yet another embodiment, the first groove 1421 is provided both on the evaporation surface 18 of the dummy area 142 and the glass surface 16 of the dummy area 142, that is, both the evaporation surface 18 of the dummy area 142 and the glass surface 16 of the dummy area 142 are provided with the first groove 142. The case that both the evaporation surface 18 of the dummy area 142 and the glass surface 18 of the dummy area 142 are provided with the first groove 142 is compared with the case that the first groove 1421 is provided only on one of the evaporation surface 18 or the glass surface 16 of the dummy area 142 in the aforementioned embodiments, and since a hardness of the evaporation surface or the glass surface provided with the first groove 1421 will be less than a hardness of the glass surface or the evaporation surface without the first groove, there is a certain degree of risk that the mask body 10 is broken in this case, thus the influence on the hardness of the mask 100 itself after the mask is tensioned is further reduced, thereby further reducing the wrinkles.

Preferably, the first groove 1421 includes a second groove having a bottom wall and a third groove having a bottom wall. The second groove is provided on the evaporation surface of the dummy area 142, and the third groove is provided on the glass surface of the dummy area 142. The second groove and the third groove are disposed apart from each other along the thickness direction of the dummy area 142, that is, an interval is formed between the bottom wall of the second groove and the bottom wall of the third groove, so as to ensure that any one of the second grooves and any one of the third grooves are not communicate with each other in the thickness direction of the dummy area 142, thereby preventing the pixel from being evaporated onto the substrate through the first groove.

Depths of the second groove and the third groove along the thickness direction of the dummy area 142 can be the same or different, and the cross-sectional shapes of the second groove and the third groove can be the same or different. For example, the depth of the second groove is greater than the depth of the third groove, or the depth of the second groove is equal to the depth of the third groove, or the depth of the second groove is less than the depth of the third groove. The depths of the second groove and the third groove may both be half of the thickness of the sub-mask 101, or the depths of the second groove and the third groove are both greater than half of the thickness of the sub-mask 101.

In one embodiment, the number of the second groove and the third groove can both be one. Preferably, the second groove has a first projection (projection in the thickness direction) facing towards a plane in which the sub-mask 101 is located. The third groove has a second projection (projection in the thickness direction) facing towards a plane in which the sub-mask 101 is located. The first projection and the second projection are at least partially overlapped, and the sum of the depths of the second groove and the third groove along the thickness direction of the dummy area 142 is less than the thickness of the dummy area 142.

Preferably, the second groove can cover most or all areas of the evaporation surface 18 of the dummy area 142, and the third groove can cover most or all areas of the glass surface 16 of the dummy area 142. The first projection and the second projection are completely overlapped. It should be understood that, in alternative embodiments, the first projection and the second projection may not be completely overlapped, for example, a method of only partial overlapping may be adopted.

In yet another embodiment, the number of the second groove and the third groove can both be at least two. Specifically, each of the second grooves has the first projection facing towards the plane in which the sub-mask 101 is located. Each of the third grooves has the second projection facing towards the plane in which the sub-mask 101 is located. The first projection and the second projection are at least partially overlapped, and the sum of the depths of the second groove and the third groove along the thickness direction of the dummy area 142 is less than the thickness of the dummy area 142.

Preferably, the first projection and the second projection can be completely overlapped. It should be understood that, in alternative embodiments, the first projection and the second projection may not be completely overlapped, for example, only a partial overlapping may be adopted.

In the present embodiment, the number of the second grooves and the third grooves may be the same or different, for example, the number of the second grooves is two and the number of the third grooves is also two, or the number of the second grooves is two and the number of the third grooves is three.

In yet another embodiment, the number of the second grooves and the third grooves can both be one. The second groove has the first projection facing the plane in which the sub-mask 101 is located. The third groove has the second projection facing the plane in which the sub-mask 101 is located. The first projection and the second projection are disposed without overlapping each other.

Preferably, there are a plurality of the first projection and the second projection, respectively. In addition, the first projection and the second projection are staggered, that is, the second groove and the third groove are staggered from each other on the plane in which the sub-mask 101 is located, and each of the first projections and each of the second projections preferably are not overlapped and are separated from each other. At this case, the sum of the depths of the adjacent second groove and third groove may be configured to be greater than the thickness of the dummy area 142, which does not cause the dummy area 142 to be penetrated in the thickness direction, and thus does not affect subsequent evaporation.

In yet another embodiment, the number of the second groove and the third groove can both be at least two. The second groove has the first projection facing towards the plane in which the dummy area 142 is located. The third groove has the second projection facing towards the plane in which the dummy area 142 is located. The first projection and the second projection are staggered from each other, and each of the first projections and each of the second projections preferably are not overlapped and are separated from each other. At this case, the sum of the depths of the adjacent second groove and third groove may be configured to be greater than the thickness of the dummy area 142, which does not cause the dummy area 142 to be penetrated in the thickness direction, and thus does not affect subsequent evaporation.

In another embodiment, both the second evaporation hole 1422 and the first groove 1421 may be provided in the dummy area 142. Specifically, the second evaporation holes 1422 are arranged apart from the first grooves 1421 on the dummy area 142, for example, one first groove 1421 is disposed between adjacent two second evaporation holes 1422, and one second evaporation hole 1422 is disposed between adjacent two first grooves 1421.

Referring to FIG. 10, in one embodiment, in order to further ensure that the difference in weight between the shielding portion 14 and the evaporation area 12 is small, at least one fourth groove 1442 is disposed in the isolation area 144 of the shielding portion 14 along the thickness direction. A depth of a single groove 1422 is less than the thickness of the sub-mask 101. Due to the presence of the fourth groove 1442, the thickness of the isolation area 144 is reduced, thus further reducing the weight of the shielding portion 14. The difference in weight between the shielding portion 14 and the evaporation area 12 is reduced, and the stress concentration of the shielding portion 14 is further reduced, so that the mask body 10 is uniformly stressed during tensioning, and the wrinkle phenomenon of the mask body during tensioning is reduced.

Specifically, the fourth groove 1442 can be provided in the isolation area 142 in one of the following three ways:
1. The fourth groove 1442 is only provided on the evaporation surface 18 of the isolation area 142.
2. The fourth groove 1442 is only provided on the glass surface 16 of the isolation area 142.
3. The fourth groove 1442 is provided both on the evaporation surface 18 and the glass surface 16 of the isolation area 142.

In addition, it should be noted that, the evaporation surface of the isolation area 142 is a portion of the evaporation surface 18 of the mask body 10, and the glass surface of the isolation area 142 is a portion of the glass surface 16 of the mask body 10.

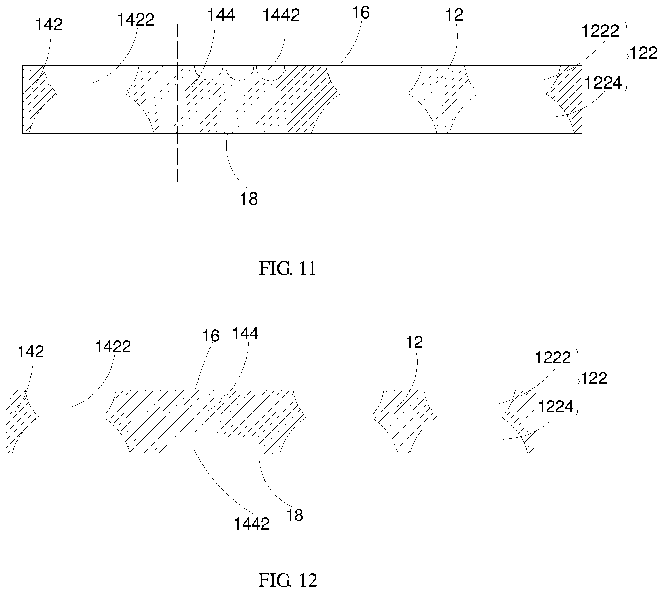

Further referring to FIG. 10 and FIG. 11, in one embodiment, the fourth groove 1442 is provided on the glass surface 16 of the isolation area 144, that is, the fourth groove 1442 is provided only on the glass surface 16 of the isolation area 144. Preferably, the number of the fourth grooves 1442 provided on the evaporation surface of the isolation area 144 is one, and one fourth groove 1442 is provided on the glass surface of the isolation area 144 in a whole surface half-etching manner. In alternative embodiments, the number of the fourth grooves 1442 provided on the glass surface of the isolation area 144 may be at least two. An interval is formed between adjacent two fourth grooves 1442. The at least two fourth grooves 1442 are provided on the glass surface 16 of the isolation area 144 in a stripe half-etching or a dotted half-etching manner.

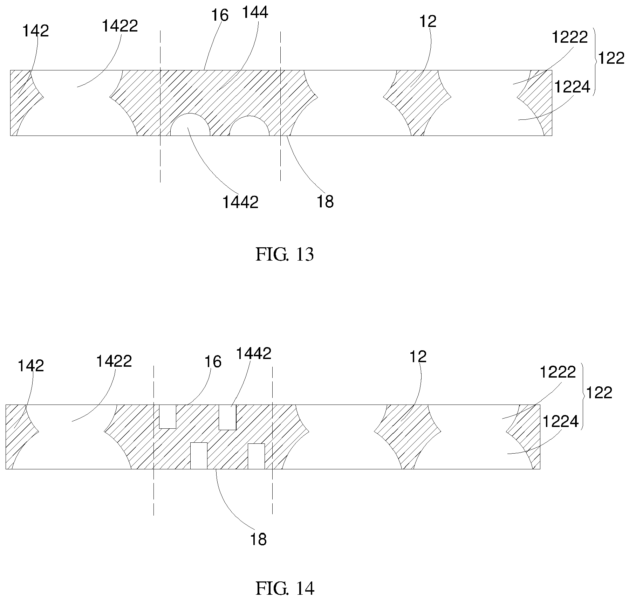

Referring to FIG. 12 and FIG. 13, in another embodiment, the fourth groove 1442 is provided on the evaporation surface 18 of the isolation area 144, that is, the fourth groove 1442 is provided only on the evaporation surface of the isolation area 144. Preferably, the number of the fourth grooves 1442 provided on the evaporation surface 18 of the isolation area 144 is one, and one fourth groove 1442 is provided on the evaporation surface 144 of the isolation area 144 in a whole surface half-etching manner. In the present embodiment, the fourth groove 1442 is disposed to cover the entire area of the evaporation surface 18 of the isolation area 144, or the fourth groove 1442 can be disposed to cover most area of the evaporation surface 18 of the isolation area 144. In addition, the cross-section of the fourth groove 1442 may have a shape of polygonal, such as triangular, rectangular, or pentagonal, or may also have a shape of circular or elliptical. When the fourth groove 1422 covers the entire area of the evaporation surface 18 of the isolation area 144, a bottom wall of the fourth groove 1422 may be exactly the same size as the evaporation surface of the isolation area 144, and the bottom wall of the fourth groove 1422 can serve as the evaporation surface of the isolation area 144.

In another embodiment, the number of the fourth grooves 1442 provided on the evaporation surface 18 of the isolation area 144 can be at least two. An interval is formed between adjacent two fourth grooves 1442. The at least two fourth grooves 1442 can be provided on the evaporation surface 18 of the isolation area 144 in a stripe half-etching or a dotted half-etching manner. When the fourth groove is stripe half-etched, the cross-section of the fourth groove 1442 is an elongated shape. When the fourth groove 1442 is dotted half-etched, the cross-section of the fourth groove 1442 has a shape of circular or elliptical. In alternative embodiments, when the fourth groove 1442 is stripe half-etched, a long side of the stripe cross-section of the fourth groove 1442 extends along a direction of a long side of the mask body 10 to further reduce the tensioning wrinkles of the mask 100.

Referring to FIG. 14, in yet another embodiment, the fourth groove 1442 is provided both on the evaporation surface 18 and the glass surface 16 of the isolation area 144, that is, both the evaporation surface 18 and the glass surface 16 of the isolation area 144 are provided with the fourth grooves 1442. The case that both the evaporation surface 18 of the isolation area 144 and the glass surface 16 of the isolation area 144 are provided with the fourth groove 1442 is compared with the case that the fourth groove 1442 is provided only on one of the evaporation surface and the glass surface of the isolation area 144 in the aforementioned embodiments (since a hardness of the evaporation surface or the glass surface provided with the fourth groove 1442 will be less than a hardness of the glass surface or the evaporation surface without the fourth groove, there is a certain degree of risk that the mask body 10 is broken in this case), the influence on the hardness of the mask 100 itself after the mask is tensioned is further reduced, thereby further reducing the wrinkles.

Preferably, the fourth groove 1442 includes a fifth groove having a bottom wall and a sixth groove having a bottom wall. The fifth groove is provided on the evaporation surface 18 of the isolation area 144, and the sixth groove is provided on the glass surface 16 of the isolation area 144. The fifth groove and the sixth groove are preferably disposed apart from each other along the thickness direction of the isolation area 144, that is, an interval is formed between the bottom wall of the fifth groove and the bottom wall of the sixth groove, so as to ensure that any one of the fifth grooves and any one of the sixth grooves are not communicate with each other in the thickness direction of the isolation area 144, thereby preventing the pixel from being evaporated onto the substrate in the isolation area 144.

Depths of the fifth groove and the sixth groove along the thickness direction of the isolation area 144 can be the same or different, and the cross-sectional shapes of the fifth groove and the sixth groove can be the same or different. For example, the depth of the fifth groove is greater than the depth of the sixth groove, or the depth of the fifth groove is equal to the depth of the sixth groove, or the depth of the fifth groove is less than the depth of the sixth groove. The depths of the fifth groove and the sixth groove may both be half of the thickness of the sub-mask 101, or the depths of the fifth groove and the sixth groove are both greater than half of the thickness of the sub-mask 101.

In one embodiment, the number of the fifth groove and the sixth groove can both be one. Specifically, the fifth groove has a first projection facing towards the plane in which the isolation area 144 is located. The sixth groove has a second projection facing towards the plane in which the isolation area 144 is located. The first projection and the second projection are at least partially overlapped, and the sum of the depths of the fifth groove and the sixth groove along the thickness direction of the isolation area 144 is less than the thickness of the isolation area 144.

Preferably, the fifth groove can cover most or all areas of the evaporation surface 18 of the isolation area 144, and the sixth groove can cover most or all areas of the glass surface 16 of the isolation area 144. The first projection and the second projection are completely overlapped. It should be understood that, in alternative embodiments, the first projection and the second projection may not be completely overlapped, for example, a method of only partial overlapping may be adopted.

In yet another embodiment, the number of the fifth groove and the sixth groove can both be at least two. Specifically, each of the fifth grooves has a third projection (projection in the thickness direction) facing towards the plane in which the isolation area 144 is located. Each of the sixth grooves has a fourth projection (projection in the thickness direction) facing towards the plane in which the isolation area 144 is located. The third projection and the fourth projection are at least partially overlapped, and the sum of the depths of the fifth groove and the sixth groove along the thickness direction of the isolation area 144 is less than the thickness of the isolation area 144.

Preferably, the third projection and the fourth projection can be completely overlapped. It should be understood that, in alternative embodiments, the third projection and the fourth projection may not be completely overlapped, for example, only a partial overlapping may be adopted.

In the present embodiment, the number of the fifth grooves and the sixth grooves may be the same or different, for example, the number of the fifth grooves is two and the number of the sixth grooves is also two, or the number of the fifth grooves is two and the number of the sixth grooves is three.

In yet another embodiment, the number of the fifth groove and the sixth groove can both be one. The fifth groove has the third projection facing towards the plane in which the isolation area 144 is located. The sixth groove has the fourth projection facing towards the plane in which the isolation area 144 is located. The third projection and the fourth projection are disposed without overlapping each other.

Preferably, there are a plurality of the third projection and the fourth projection, respectively. In addition, the third projection and the fourth projection are staggered. That is, the fifth groove and the sixth groove are staggered from each other on the plane in which the isolation area 144 is located, and each of the third projections and each of the fourth projections preferably are not overlapped and are separated from each other. At this case, the sum of the depths of the adjacent fifth groove and sixth groove may be configured to be greater than the thickness of the isolation area 144, which does not cause the isolation area 144 to be penetrated in the thickness direction, and thus does not affect subsequent evaporation.

In yet another embodiment, the number of the fifth groove and the sixth groove can both be at least two. The fifth groove has the first projection facing towards the plane in which the isolation area 144 is located. The sixth groove has the second projection facing towards the plane in which the isolation area 144 is located. The first projection and the second projection are staggered from each other, and each of the third projections and each of the fourth projections preferably are not overlapped and are separated from each other. At this case, the sum of the depths of the adjacent fifth groove and sixth groove may be configured to be greater than the thickness of the isolation area 144, which does not cause the isolation area 144 to be penetrated in the thickness direction, and thus does not affect subsequent evaporation.

In alternative embodiments, a third evaporation hole may also be disposed in the isolation area 144, or the third evaporation hole and the fourth groove 1442 are both disposed in the isolation area 144. Preferably, the third evaporation holes are spaced apart from the fourth grooves 1442 on the isolation area 144, for example, one fourth groove 1442 is disposed between adjacent two third evaporation holes, and one fourth evaporation hole is disposed between adjacent two fourth grooves 1442.

In the mask provided by the embodiments of the present disclosure, the shielding portion 14 is divided into two parts, and the dummy area 142 is provided with the second evaporation hole 1422 or the first groove 1421. When the mask 100 is used for evaporation, evaporation materials can be evaporated onto the substrate from the first evaporation hole 122 and the second evaporation hole 1422. The arrangement of the second evaporation hole 1422 or the first groove 1421 can reduce the weight of the shielding portion 14, reduce the difference in weight between the shielding portion 14 and the evaporation area 12, and reduce the stress concentration of the shielding portion 14, so that the mask body 10 is stressed uniformly during tensioning, further reducing the wrinkle phenomenon of the mask body 10 during tensioning. In addition, the isolation area 144 is disposed between the dummy area 142 and the evaporation area 12 to facilitate cutting and packaging of the subsequently manufactured display screen.

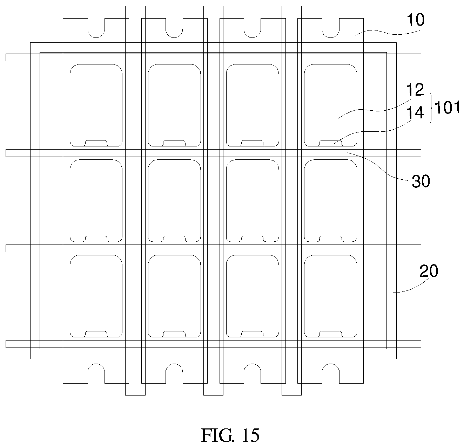

Referring to FIG. 15, an embodiment of the present disclosure further provides a mask assembly, which includes a mask frame 20, a support strip 30, and at least one aforementioned mask 100. The mask 100 includes a mask body 10, on which at least one sub-mask 101 is disposed. The support strip 30 is fixedly connected to the mask frame 20, and at least one mask 100 is laminated on the support strip 30 and fixedly connected with the mask frame 30.

During a working process of the mask assembly, the evaporation surface of the mask 100 faces the evaporation source, the glass surface of the mask 100 faces the substrate, and the support strip 30 is located on the evaporation surface of the mask 100, so as to prevent the mask 100 from sagging during the evaporation process, further reducing the wrinkling of the mask 100 during tensioning.

The technical features of the above-described embodiments may be combined in any combination. For the sake of brevity of description, all possible combinations of the various technical features in the above embodiments are not described. However, as long as there is no contradiction in the combination of these technical features, it should be considered as the scope of the present specification.

The foregoing embodiments are merely illustrative of several embodiments of the present disclosure, and the description thereof is more specific and detailed, but is not to be construed as limiting the scope of the disclosure. It should be noted that any variation or replacement readily figured out by a person skilled in the art without departing from the concept of the present disclosure shall all fall within the protection scope of the present disclosure. Therefore, the protection scope of the present disclosure shall be subject to the protection scope of the appended claims.

## Claims

1. A mask, comprising:
a mask body having an evaporation surface and a glass surface, the evaporation surface being disposed facing an evaporation source, the glass surface being disposed away from the evaporation source; and
at least one sub-mask disposed on the mask body, the sub-mask comprising an evaporation area and a shielding portion, the evaporation area being provided with a first evaporation hole penetrating the sub-mask in a thickness direction of the sub-mask, the shielding portion comprising an isolation area and a dummy area, the dummy area corresponding to an irregular-shaped area of a display screen, the isolation area being located between the dummy area and the evaporation area, the dummy area being provided with a second evaporation hole penetrating the sub-mask in the thickness direction of the sub-mask, and/or the dummy area being provided with ore or more first grooves, a depth of the first groove being less than a thickness of the sub-mask.

2. The mask according to claim 1, wherein the second evaporation hole has a shape same to that of the first evaporation hole.

3. The mask according to claim 1 or claim 2, wherein the second evaporation hole comprises a first half-etching hole and a second half-etching hole, the first half-etching hole and the second half-etching hole are disposed along the thickness direction of the sub-mask and in communication with each other;
the first half-etching hole is disposed on the glass surface, the second half-etching hole is disposed on the evaporation surface, the first half-etching hole gradually shrinks from one end of the mask body adjacent to the glass surface to the other end of the mask body away from the glass surface, the second half-etching hole gradually shrinks from one end of the mask body adjacent to the evaporation surface to the other end of the mask body away from the evaporation surface, and the second half-etching hole is in communication with the first half-etching hole.

4. The mask according to claim 3, wherein a projection of an opening of the first half-etching hole along the thickness direction of the sub-mask is located within an opening of the second half-etching hole.

5. The mask according to claim 1, wherein the first groove is disposed on the evaporation surface or the glass surface.

6. The mask according to claim 1, wherein the first groove comprises a second groove and a third groove, the second groove is disposed on the evaporation surface, the third groove is disposed on the glass surface; an interval is formed between a bottom wall of the second groove and a bottom wall of the third groove along the thickness direction of the sub-mask.

7. The mask according to claim 1, wherein a cross-section of the first groove has a shape of polygonal, circular, or elliptical.

8. The mask according to claim 1, wherein the isolation area is provided with at least one fourth groove in the thickness direction of the sub-mask, a depth of the fourth groove is less than the thickness of the sub-mask.

9. The mask according to claim 8, wherein the fourth groove is disposed on the evaporation surface or the glass surface.

10. The mask according to claim 8, wherein the fourth groove comprises a fifth groove and a sixth groove, the fifth groove is disposed on the evaporation surface, the sixth groove is disposed on the glass surface, an interval is formed between a bottom wall of the fifth groove and a bottom wall of the sixth groove along the thickness direction of the sub-mask.

11. The mask according to claim 10, wherein a depth of the fifth groove is greater than or equal to a depth of the sixth groove.

12. The mask according to claim 8, wherein a cross-section of the fourth groove has a shape of polygonal, circular, or elliptical.

13. The mask according to claim 1, wherein the mask body has a first center line and a second center line in a plan, the first center line is perpendicular to the second center line;
the mask body is provided with two sets of the sub-masks, each set of the sub-masks comprises at least one of the sub-masks, an interval is formed between adjacent two sub-masks, the two sets of the sub-masks are axisymmetric with respect to the first center line, and the two sets of the sub-masks are axisymmetric with respect to the second center line.

14. The mask according to claim 13, wherein the shielding portions of the sub-masks located on a same side of the second center line are disposed away from or facing to the second center line.

15. The mask according to claim 13, wherein each set of the sub-masks comprises at least one sub-set of sub-masks, each of the sub-sets of the sub-masks comprises two adjacent sub-masks, the shielding portions of the two connected sub-masks of each of the sub-sets of the sub-masks are oppositely disposed.

16. The mask according to claim 1, wherein the mask body is provided with a plurality of sub-masks, the plurality of sub-masks are disposed in a row or in an array;
the mask body has a virtual dividing line, the virtual dividing line divides the plurality of sub-masks into two sets of sub-masks, the two sets of sub-masks comprise: a first set of sub-masks located on one side of the virtual dividing line and a second set of sub-masks located on the other side of the virtual dividing line; the first set of sub-masks and the second set of sub-masks comprises at least one sub-mask, respectively;
each of the sub-masks of the first set of sub-masks and the second set of sub-masks is provided with the shielding portion on a side facing the virtual dividing line, respectively; or each of the sub-masks of the first set of sub-masks and the second set of sub-masks is provided with the shielding portion on a side facing away from the virtual dividing line, respectively.

17. The mask according to claim 16, wherein the virtual dividing line is a virtual straight line.

18. The mask according to claim 1, wherein the mask body is provided with a plurality of sub-masks, the plurality of sub-masks are disposed in a row or in an array;
a plurality of sequentially adjacent sub-sets of sub-masks are formed by an even number of the sequentially adjacent sub-masks in a same row, each of the sub-sets of the sub-masks comprises two sub-masks disposed adjacent to each other;
opposite sides of the two sub-masks of each of the sub-sets of the sub-masks are provided with the shielding portions, respectively, sides thereof away from each other are not provided with the shielding portions; or opposite sides of the two sub-masks of each of the sub-sets of the sub-masks are not provided with the shielding portions, sides thereof away from each other are provided with the shielding portions, respectively.

19. The mask according to claim 1, wherein the isolation area is a virtual line matching a contour line of a recessed portion of the evaporation area.

20. A mask assembly, comprising a mask frame, a support strip, and at least one mask of any one of claims 1 to 19, the support strip being fixedly connected to the mask frame, at least one of the masks being laminated on the support strip and fixedly connected with the mask frame.
